# FASCICULE DE BREVET EUROPEEN

(11) **EP 0 374 998 B1**
(45) Date de publication et mention de la délivrance du brevet: **25.08.1993**
(21) Numéro de dépôt: 89203045.3
(22) Date de dépôt: 30.11.1989
(51) Int. Cl.: G07C 5/08, G01R 31/00

(54) **Procédé et dispositif de diagnostic des défauts sur des boîtiers électriques ou électroniques embarqués sur véhicule automobile**
Verfahren und Anordnung zur Fehlerdiagnose an elektrischen oder elektronischen Gehäusen an Bord eines Kraftfahrzeugs
Method and apparatus for diagnosing defects on electric or electronic casings in a motor vehicle

(30) Priorité: 22.12.1988 FR 8817368
(43) Date de publication de la demande: 27.06.1990
(73) Titulaire: ACTIA Société Anonyme, F-31432 Toulouse Cédex 04 (FR)
(72) Inventeur: Bethencourt, Gilles, F-31520 Ramonville Saint-Agne (FR); Fonté, Jean-Claude, F-33140 Aucamville (FR)
(74) Mandataire: Barre, Philippe

(56) Documents cités:
- EP-A- 0 005 436
- EP-A- 0 039 122
- EP-A- 0 141 050
- EP-A- 0 225 971
- EP-A- 0 231 607
- EP-A- 0 231 743
- WO-A-88/02122
- GB-A- 2 081 909

## Description

L'invention concerne un procédé de diagnostic des défauts sur des boîtiers électriques ou électroniques embarqués sur véhicule automobile, boîtiers du type recevant des signaux d'état caractérisant l'état statique et dynamique d'organes du véhicule, et engendrant des signaux électriques de commande desdits organes, l'ensemble desdits signaux d'état et signaux de commande étant représentatifs d'un ensemble de paramètres spécifiques du véhicule. Cette invention s'étend à un dispositif de diagnostic obtenu par la mise en oeuvre de ce procédé.

Les dispositifs actuels utilisés pour effectuer des diagnostics sur des boîtiers électroniques ou électriques embarqués sur véhicule consistent en des stations de diagnostic alimentées sur le secteur et permettant d'effectuer des tests dans des ateliers de réparation. Ces stations sont connectées à un faisceau de câbles disposé au préalable en série sur le faisceau reliant un boîtier à un organe donné, et dont adaptées pour calibrer et traiter les signaux d'état et de commande traversant ce faisceau, en vue d'afficher sur un écran les paramètres de fonctionnement de l'organe précité. Les principaux inconvénients de ces stations proviennent de leur prix de revient très élevé et du fait que, de par leur conception, leur emploi est limité à des tests statiques. De plus, ces stations ne sont pas adaptées pour tester, lors d'un branchement donné, l'ensemble des signaux d'état ou de commande reçus ou engendrés par un boîtier, mais uniquement les signaux reçus d'un organe spécifique (ou engendrés vers cet organe) reliés au boîtier. Le test de tout autre organe relié au boîtier nécessite donc le branchement d'un autre faisceau. En outre, les seules valeurs affichées concernent les mesures de paramètres de fonctionnement du véhicule dont l'interprétation nécessite un personnel qualifié et l'utilisation de manuels de réparation très complets. Enfin, leur conception rend très coûteuse toute adaptation à de nouveaux types de boîtiers électroniques ou électriques.

D'autre part, il existe également des dispositifs de diagnostic tel que celui décrit dans le brevet EP-A-0.231.607, adaptés pour se connecter par une liaison série sur des boîtiers électroniques ou électriques spécifiques possédant leurs propres moyens de traitement des signaux d'état et de commande qu'ils reçoivent ou engendrent. Ces boîtiers sont adaptés pour délivrer, via la liaison série, des signaux calibrés vers le dispositif de diagnostic. La fonction de ce dispositif de diagnostic est de décoder la salve de signaux délivrés en vue de son affichage. L'inconvénient de tels dispositifs réside dans le fait que leur emploi est limité aux boîtiers électroniques ou électriques équipés pour délivrer une trame diagnostic. De plus, les paramètres de fonctionnement affichés sont limités aux signaux délivrés par les boîtiers. Enfin, comme pour les stations de diagnostic, les seules valeurs affichées concernent les mesures de paramètres de fonctionnement dont l'interprétation nécessite l'utilisation de manuels de réparation très complets.

La présente invention vise à pallier les inconvénients des dispositifs connus et a pour premier objectif de fournir un dispositif de diagnostic de faible prix de revient par rapport à celui des stations de diagnostic, permettant de tester tous les types de boîtiers possédant ou non une trame de diagnostic.

Un autre objectif de l'invention est de permettre d'affectuer des tests routiers grandeur réelle.

Un autre objectif est de permettre de détecter et d'afficher les défauts fugitifs survenant lors d'un essai routier.

Un autre objectif est de fournir directement à l'opérateur l'interprétation du signal de défaut détecté et de guider ce dernier en vue de la réparation à effectuer.

Un autre objectif est de fournir un dispositif adaptable à faible coût à tout nouveau type de boîtier.

A cet effet, l'invention vise un procédé de diagnostic des défauts sur des boîtiers électriques ou électroniques embarqués sur véhicule automobile, boîtiers du type recevant des signaux électriques d'état caractérisant l'état statique et dynamique d'organes du véhicule et engendrant des signaux électriques de commande desdits organes, l'ensemble desdits signaux d'état et signaux de commande étant représentatifs à chaque instant d'un ensemble de paramètres spécifiques du véhicule, dits paramètres de fonctionnement, le ou les boîtiers à tester pour un véhicule donné étant désigné par "système à tester".

Selon l'invention, ce procédé se caractérise en ce qu'il consiste :
. à mémoriser préalablement dans des mémoires de stockage, d'une part, des programmes de diagnostic correspondant chacun à un type de système à tester, d'autre part, associés à chaque programme de diagnostic, un ensemble de seuils de défaut liés à chaque paramètre de fonctionnement correspondant au système concerné,
. à prélever en continu les signaux d'état et signaux de commande aux bornes des boîtiers du système à tester, de façon à disposer en continu desdits signaux sur un faisceau de dérivation,
. à mettre en forme, simultanément et en parallèle, lesdits signaux en vue de les ramener dans une plage de valeurs prédéterminée et d'obtenir des signaux calibrés,
. à sélectionner par une commande manuelle le programme de diagnostic correspondant au type de système testé, et les seuils de défaut associés,
. à configurer un multiprocesseur au moyen du programme de diagnostic sélectionné, en vue de le dédier au traitement des signaux d'état et signaux de commande spécifiques du type de système testé, et d'affecter un caractère prioritaire à un des signaux d'état ou de commande de type périodique,
. à numériser, au moyen du multiprocesseur configuré, les signaux calibrés et des combinaisons desdits signaux sur une période liée au signal prioritaire, de durée inférieure à celle de la période dudit signal prioritaire, de façon à engendrer au cours de ladite période un ensemble de signaux numériques représentatifs des signaux calibrés,
. à mémoriser les signaux numériques obtenus à chaque période dans une mémoire vive,
. à explorer ladite mémoire vive à chaque période et à calculer en temps réel un ensemble de grandeurs représentatives des paramètres de fonctionnement pour la période considérée,
. à comparer en temps réel chaque grandeur calculée aux seuils de défaut préalablement mémorisés et sélectionnés, en vue d'engendrer un signal de défaut en cas de dépassement,
. à stocker en temps réel pour chaque grandeur l'éventuel signal de défaut dans une mémoire sauvegardée ayant une première zone de capacité au moins égale au nombre de paramètres de fonctionnement,
. à décompter, pour chaque grandeur, le nombre d'apparitions du signal de défaut correspondant et à mémoriser au moins une donnée liée à ce nombre dans une seconde zone de la mémoire sauvegardée,
. à afficher, à la demande, le contenu de ladite mémoire sauvegardée.

Ce procédé permet donc, en temps réel, de calculer des grandeurs représentatives des paramètres de fonctionnement correspondant au système testé et de stocker dans une mémoire sauvegardée les éventuels signaux de défauts qui peuvent ensuite être affichés à la demande. Il autorise donc d'effectuer des tests de roulage normal, en lieu et place des tests statiques actuellement effectués, et de surveiller lors de cet essai tous les signaux d'état ou de commande reçus ou engendrés par le système testé. Ainsi, tout défaut même fugitif intervenant lors de cet essai est détecté et mémorisé.

Selon un mode de mise en oeuvre préférentiel :
. préalablement à l'affichage du contenu de la mémoire sauvegardée, on sélectionne une combinaison déterminée d'informations à afficher parmi un ensemble de combinaisons correspondant à différents types de diagnostic,
. l'on affiche uniquement la combinaison d'informations sélectionnées.

Comme on le comprendra mieux plus loin, plusieurs types de diagnostic autres que le diagnostic routier peuvent ainsi être effectués et notamment : vérification du cablage de la chaîne de mesure, mesure des paramètres se rapportant au système testé... Pour chacun de ces diagnostics, seules les informations sélectionnées sont en outre affichées.

Par ailleurs, la sélection du programme de diagnostic du système à tester et de la combinaison d'informations à afficher s'effectuent préférentiellement :
. en engendrant l'affichage successif de menus portant des indications représentatives des types de système à tester mémorisés et de l'ensemble des combinaisons à afficher,
. en actionnant un curseur de choix d'indications contenues dans le menu.

Cette sélection s'effectue donc facilement par lecture de menus successifs et arborescents comportant les diverses caractéristiques nécessaires à la mise en oeuvre du procédé pour un système à tester et un type de diagnostic donnés.

De plus, selon une autre caractéristique de l'invention :
. on mémorise dans une mémoire de stockage une table d'aides à la réparation comportant pour chaque signal de défaut des informations d'aide à la réparation,
. on affiche à la demande les informations de cette table qui correspondent à un signal de défaut lorsqu'est affiché ce signal de défaut.

Cette table d'aides intégrant des informations de dépannage liées aux signaux de défaut affichés constitue un guide fournissant directement à l'utilisateur l'origine de la panne.

L'invention s'étend à un dispositif de diagnostic se caractérisant en ce qu'il comprend en combinaison :
- un jeu de faisceaux de dérivation, chaque faisceau comportant à une extrémité un connecteur standard et à son autre extrémité un connecteur-dérivateur adapté pour se brancher aux bornes des boîtiers d'un système à tester en vue d'en dériver les signaux d'état et signaux de commande,
- une interface de mise en forme dotée de connecteurs d'entrée conjugués des connecteurs standards des faisceaux de dérivation, ladite interface comprenant une pluralité de modules de calibrage agencés en parallèle sur les entrées,
- un multiprocesseur, relié à l'interface de mise en forme et comprenant une pluralité de compteurs et de convertisseurs analogique/numérique, au moins deux processeurs organisés en maître/esclave une mémoire vive de mémorisation en temps réel des signaux numériques obtenus et une mémoire sauvegardée ayant une première zone pour le stockage de signaux de défaut et une seconde zone pour mémoriser des données liées au nombre d'apparitions de chaque signal de défaut,
- des mémoires de stockage d'un ensemble de programmes de diagnostic correspondant à un ensemble de systèmes à tester, lesdites mémoires étant reliées au multiprocesseur,
- des moyens de connexion adaptés pour connecter le multiprocesseur avec une interface homme/machine possédant des moyens d'affichage et des moyens de sélection manuelle,
- des moyens d'alimentation électrique pourvus d'un connecteur en vue de leur branchement sur une batterie de véhicule automobile, lesdits moyens étant adaptés pour convertir la tension batterie en une tension régulée propre à l'alimentation du dispositif.

Comme on le verra plus loin, outre les avantages ci-dessus cités , la conception de ce dispositif permet de réaliser un boîtier de diagnostic de dimensions adaptées pour être embarqué à l'intérieur d'un véhicule, soit dans le compartiment moteur, soit dans l'habitacle, en vue d'effectuer des tests routiers.

De plus, selon deux autres caractéristiques de l'invention :
- l'interface de mise en forme est constituée d'une carte interchangeable comportant un connecteur d'entrée débrochable possédant une pluralité de voies, conjugué de connecteurs standard, un connecteur de sortie débrochable possédant une pluralité de voies en vue de la liaison avec le multiprocesseur et, agencés en parallèle entre ces connecteurs, les modules de calibrage.
- les mémoires de stockage des programmes de diagnostic sont portées par une carte interchangeable comportant un connecteur bidirectionnel débrochable, en vue de la liaison desdites mémoires avec le multiprocesseur.

Ce système de carte interchangeable permet, à faible coût, d'adapter le dispositif de diagnostic aux différentes évolutions des systèmes à tester et, par conséquent, de fournir un dispositif ouvert à tous les développements technologiques des véhicules automobiles.

L'invention s'étend enfin, en tant que moyen essentiel pour la réalisation de ce dispositif de diagnostic, à une carte d'interface de mise en forme, caractérisée en ce qu'elle comprend :
- un connecteur d'entrée débrochable possédant une pluralité de voies,
- un connecteur de sortie débrochable possédant une pluralité de voies,
- une pluralité de modules de calibrage agencés en parallèle entre les connecteurs d'entrée et de sortie.

D'autres caractéristiques, buts et avantages de l'invention ressortiront de la description détaillée qui suit en référence aux dessins annexés qui en représentent à titre d'exemples non limitatifs un mode de réalisation préférentiel et une variante de réalisation. Sur ces dessins qui font partie intégrante de la présente description :

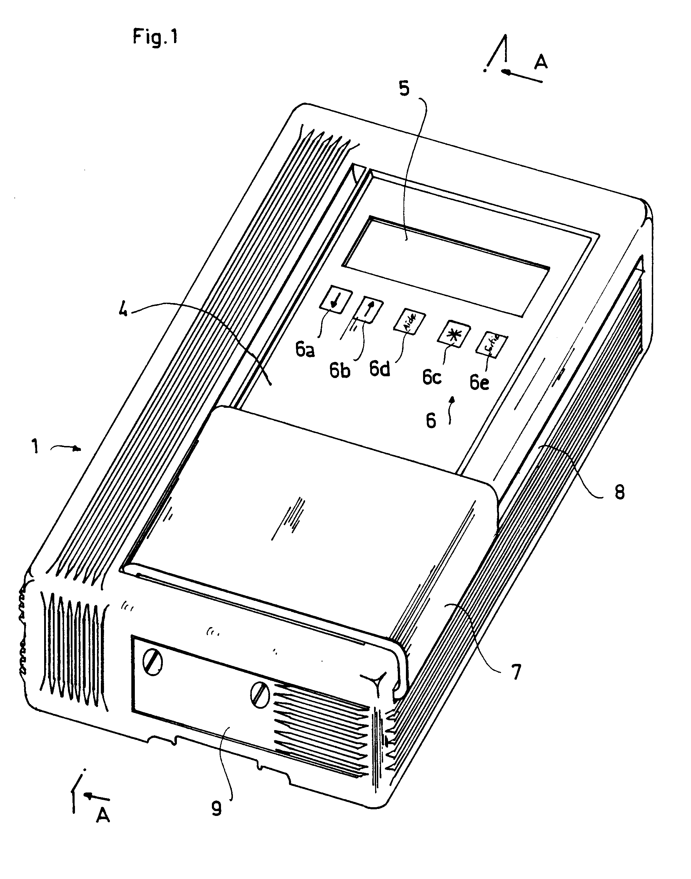

- la figure 1 est une vue en perspective d'un dispositif de diagnostic conforme à l'invention,

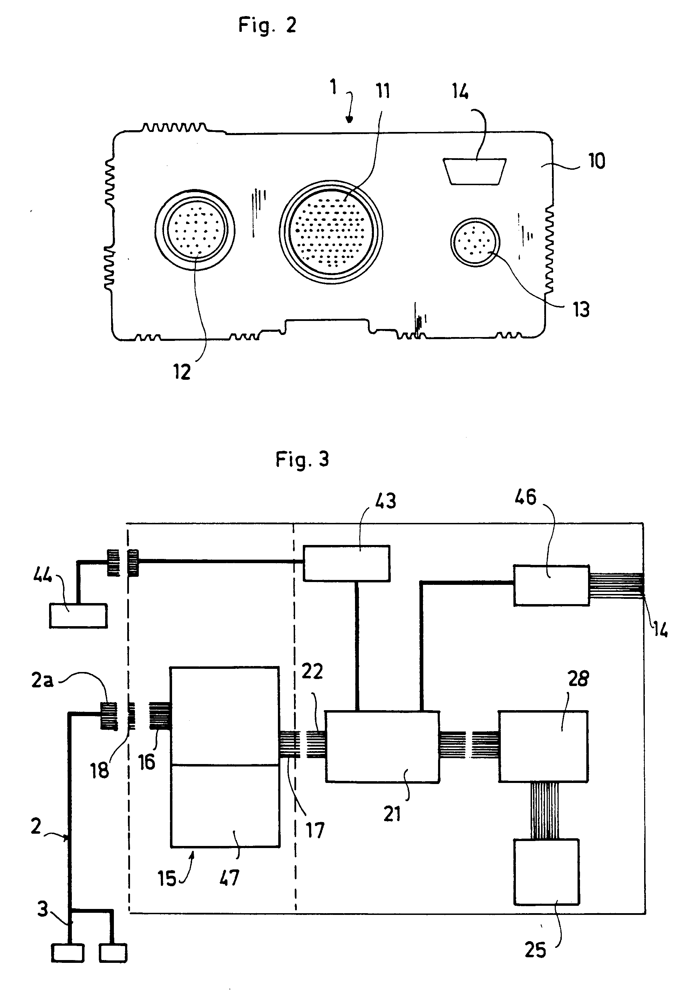

- la figure 2 est une vue de face d'une des faces d'extrémités de ce dispositif,
- la figure 3 est un schéma synoptique de ce dispositif,

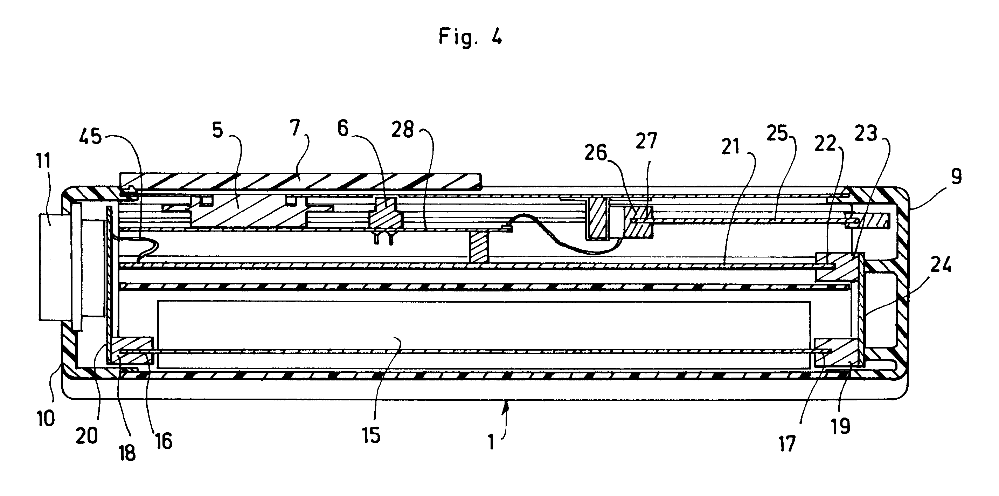

- la figure 4 en est une coupe longitudinale par un plan vertical A,
- les figures 5, 6, 7 sont des schémas électroniques des modules de calibrage de ce dispositif,
- la figure 8 est un schéma synoptique du multiprocesseur de ce dispositif,
- la figure 9 est un schéma synoptique d'une variante de réalisation,
- la figure 10 représente le logigramme de fonctionnement général de ce dispositif.

Le dispositif de diagnostic représenté aux figures se présente sous la forme d'un boîtier de diagnostic 1 de forme parallélépipédique rectangle. Ce boîtier 1 est destiné à être raccordé aux bornes de boîtiers électroniques ou électriques par l'intermédiaire de faisceaux électriques 2 dotés d'un dérivateur 3 permettant de dériver vers le dispositif les signaux d'état reçus par ces boîtiers électroniques et les signaux de commande engendrés par ces derniers.

Le boîtier de diagnostic 1 présente une hauteur de l'ordre de 80 mm, une largeur de l'ordre de 150 mm et une longueur de l'ordre de 300 mm et est réalisé en aluminium. Ces dimensions et ce matériau permettent de l'embarquer facilement à l'intérieur d'un véhicule, soit dans le compartiment moteur, soit dans l'habitacle de ce dernier.

Une des faces frontales de ce boîtier de diagnostic comprend une fenêtre 4 à l'arrière de laquelle sont disposés un écran alphanumérique 5 de quatre lignes de 20 caractères, et cinq boutons étanches 6 de sélection manuelle. Cette face frontale est en outre dotée d'un capot de protection 7 monté sur glissières 8 pour pouvoir se déplacer entre deux positions : une position où il masque et protège l'écran d'affichage 5 et les boutons de sélection manuelle 6, et une position où il découvre ces derniers.

Par ailleurs, le boîtier de diagnostic 1 est ouvert à ses deux extrémités et doté intérieurement de glissières longitudinales d'enfichage de cartes. Les extrémités ouvertes sont en outre fermées par deux embouts, l'un amovible 9 portant les liaisons intercartes et l'autre fixe 10 portant des connecteurs accessibles : un connecteur 63 voies 11 et un connecteur 28 voies 12 conjugués des connecteurs standard 2a de faisceaux de dérivation 2, un connecteur d'alimentation 13 et un connecteur 9 voies 14.

Les cartes renfermées à l'intérieur de ce boîtier de diagnostic 1 sont au nombre de quatre :
- une carte interchangeable de mise en forme 15 comportant un connecteur d'entrée débrochable 16 possédant une pluralité de voies conjuguées des connecteurs standard 2a des faisceaux de dérivation 2, et un connecteur de sortie débrochable 17 possédant une pluralité de voies. Cette carte de mise en forme 15 vient s'enficher dans des connecteurs encartables 18, 19 portés respectivement par chacun des embouts 9, 10, le connecteur 18 porté par l'embout fixe 10 étant relié par un circuit électrique 20 aux connecteurs 63 voies 11 et 28 voies 12 et au connecteur d'alimentation 13,
- une carte multiprocesseur fixe 21 comportant un connecteur d'entrée débrochable 22 venant s'enficher dans un connecteur encartable 23 porté par l'embout amovible 9 et relié par un circuit électrique 24 au connecteur encartable 19 connecté à l'interface de mise en forme 15,
- une carte interchangeable 25 portant les mémoires de stockage des programmes de diagnostic correspondant à un ensemble de systèmes à tester. Cette carte 25 vient s'enficher dans un connecteur encartable fixe 26 et comporte un connecteur bidirectionnel débrochable 27 en vue de la liaison des mémoires de diagnostic avec la carte multiprocesseur 21,
- une carte fixe 28 de connexion avec les moyens d'affichage et de sélection manuelle 5, 6 reliée de façon débrochable, d'une part, à la carte multiprocesseur 21 et, d'autre part, au connecteur encartable fixe 26 de la carte des mémoires de stockage 25, de façon à assurer la liaison entre cette dernière et la carte multiprocesseur 21.

En premier lieu, la carte de mise en forme 15 comprend, agencés en parallèle entre ses connecteurs 16, 17, une pluralité de modules de calibrage du type suivant : module 29 de comparaison du signal d'état ou de commande avec un seuil de calibrage, en vue de délivrer un signal logique fonction de la comparaison, module 31 amplificateur suiveur apte à réaliser une adaptation en vue de délivrer un signal analogique calibré, et module 30 contrôleur de masse apte à comparer l'impédance d'entrée à un seuil de calibrage en vue de délivrer un signal logique fonction de la comparaison.

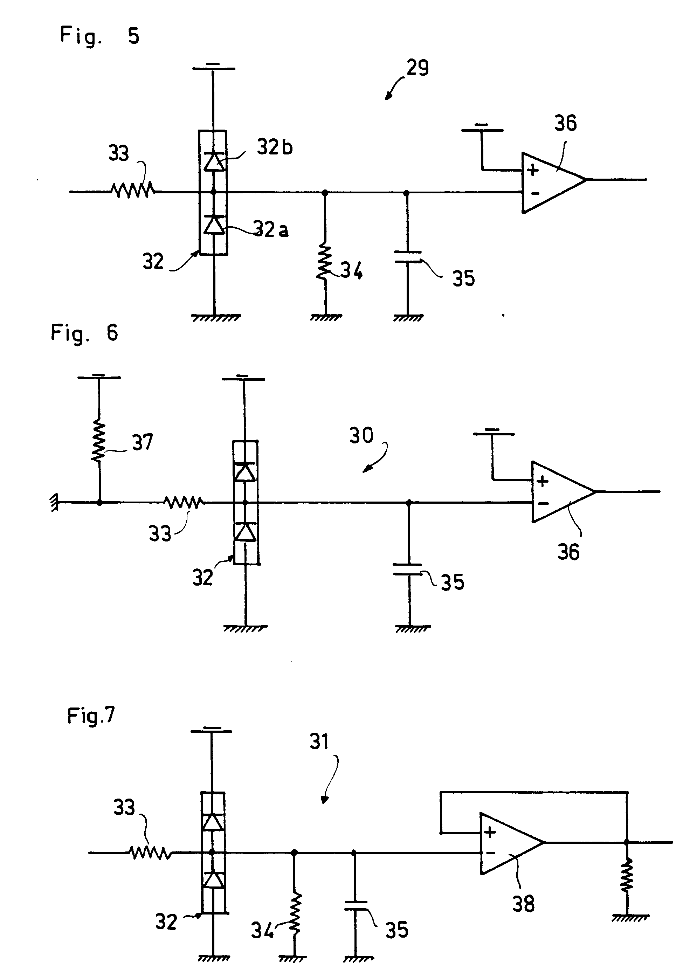

Tel que représenté à la figure 5, les modules de comparaison 29 comprennent un bloc de protection d'entrée 32 comportant deux diodes 32a, 32b, adapté pour permettre de délivrer un signal de tension s'étendant dans une plage de valeurs comprise sensiblement entre la tension d'alimentation et la masse. De part et d'autre de ce bloc de protection sont disposées des résistances 33, 34 destinées à abaisser l'intensité du courant prélevé de façon à ne pas perturber le fonctionnement de l'organe testé. Le signal est ensuite filtré au moyen d'une capacité de filtrage 35 puis délivré vers l'entrée moins d'un comparateur 36 dont l'entrée plus est alimenté au moyen d'une tension de référence. Ce comparateur 36 délivre un signal logique de niveau 0 ou 1 en fonction de la tension du signal d'entrée alimentant son entrée moins.

Tel que représenté à la figure 6, les modules contrôleur de masse 30 présentent le même principe que les modules de comparaison 29 ci-dessus décrits. Ils comportent toutefois en lieu et place de la résistance 34 de ces modules 29, une résistance 37 connectée entre la tension d'alimentation et le circuit de masse associé et adaptée pour délivrer vers l'entrée moins du comparateur 36 un signal de tension déterminée définissant un fonctionnement normal.

Les modules suiveurs 31 représentés à la figure 7 sont identiques aux modules de comparaison 29 quant aux composants utilisés, mis à part le comparateur 36 remplacé par un amplificateur 38 monté en suiveur et adapté pour délivrer une tension comprise entre 0 et 5 volts identique à sa tension d'entrée sans toutefois perturber le fonctionnement de l'organe testé.

Les signaux logiques et analogiques calibrés par la carte de mise en forme 15 sont délivrés en parallèle vers le connecteur d'entrée débrochable 22 de la carte multiprocesseur 21.

Cette carte multiprocesseur 21 comporte en premier lieu deux microcontrôleurs : un microcontrôleur maître 39 et un microcontrôleur esclave 40 vers lesquels sont réparties les voies du connecteur d'entrée débrochable 22.

Chaque microcontrôleur 39, 40 comporte un processeur, au moins six compteurs associés par groupes de puissance différente, en vue d'effectuer des mesures de temps sur les signaux calibrés logiques et sur des combinaisons de complexités différentes de ces signaux, et une pluralité de convertisseurs à plusieurs voies, en nombre adapté pour la numérisation en parallèle des signaux calibrés analogiques. Le microcontrôleur maître 39 comporte ainsi 4 convertisseurs et l'esclave 40 en comporte 11. Ces microcontrôleurs 39, 40 comportent enfin chacun une mémoire vive de mémorisation en temps réel des signaux numériques obtenus.

Le dialogue entre ces microcontrôleurs 39, 40 est établi par l'intermédiaire d'une mémoire vive 41 dans laquelle ces microcontrôleurs écrivent et lisent.

En dernier lieu, le multiprocesseur 21 comporte une mémoire sauvegardée 42 pour le stockage de signaux de défaut et données liées à ces signaux de défaut.

Cette carte multiprocesseur 21 comporte, en outre, un convertisseur d'alimentation 43, de type connu en soi, adapté pour délivrer à partir de la tension de la batterie 44 d'un véhicule automobile une tension régulée de cinq volts.

La carte multiprocesseur 21 est par ailleurs reliée par circuit électrique au connecteur 9 voies 14 en vue d'une connexion sur un système extérieur d'échange avec le multiprocesseur. Cette liaison est une liaison série conforme à la norme RS232C et à cet effet la carte multiprocesseur 21 comprend une interface 46 d'adaptation de signaux de type connu en soi. Cette liaison série est utilisée en vue de faire fonctionner le dispositif de diagnostic en aveugle, les moyens de sélection et d'affichage étant déportés dans un système extérieur tel que station de diagnostic.

La carte multiprocesseur 21 comporte enfin une deuxième liaison série utilisant deux voies du connecteur 63 voies 11 et transitant par la carte de mise en forme 15 vers le multiprocesseur. Cette liaison série est conforme à la norme ISO DP 9141 de septembre 1986 et du type K et L. Elle permet le traitement des salves de diagnostics délivrées par les boîtiers électroniques ou électriques spécifiques décrits dans le préambule.

La carte interchangeable 25 porte, quant à elle, les deux mémoires de stockage des programmes de diagnostic de chacun des deux microcontrôleurs 39, 40.

En dernier lieu, ce dispositif de diagnostic est associé à un jeu de faisceaux de dérivation 2 comportant des résistances câblées dans lesdits faisceaux, et différentes d'un faisceau à l'autre. Ces résistances constituent des paramètres électriques identifiant chaque système à tester, auxquels est associé, dans chaque programme de diagnostic, un code représentatif dudit système à tester.

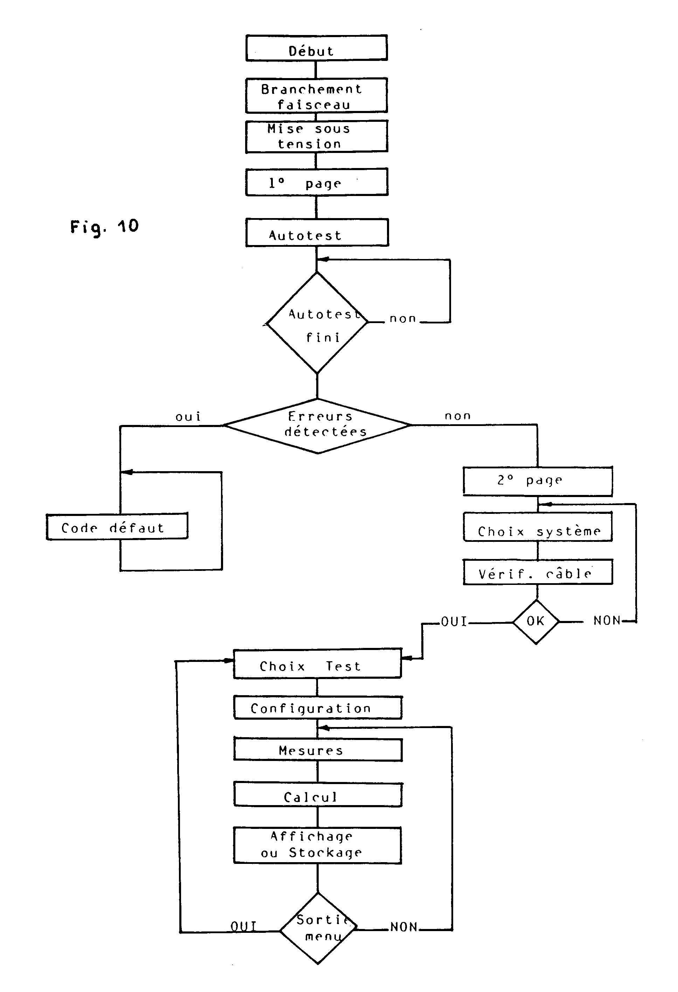

Le logigramme de fonctionnement général de ce dispositif de diagnostic est représenté à la figure 10. Les étapes préalables consistent à raccorder le boîtier de diagnostic 1 aux bornes d'un boîtier électronique au moyen d'un faisceau de dérivation 2 présélectionné, puis de mettre le boîtier de diagnostic 1 sous tension.

A partir de cette mise sous tension, une page de garde est affichée sur l'écran alphanumérique et les processeurs maître 39 et esclave 40 procèdent à leur propre autotest consistant à tester le bon fonctionnement des organes du multiprocesseur. Le bilan de cet autotest est effectué par le processeur maître 39 qui reçoit notamment les résultats de l'autotest du processeur esclave 40. Lorsque des erreurs ont été détectées lors de cet autotest, il est affiché un code d'erreur associé à l'organe en défaut.

Dans le cas contraire, l'étape suivante consiste à sélectionner le type de système à tester.

Pour effectuer ce choix, l'utilisateur dispose d'un menu comportant les divers types de systèmes pouvant être testés. Il fait défiler à l'écran 5 les lignes de ce menu au moyen de deux touches descente 6a et montée 6b et sélectionne la ligne désirée au moyen d'une touche VALID. 6c.

Une fois ce choix effectué, le multiprocesseur vérifie la concordance entre le paramètre électrique du faisceau 2 et le code mémorisé dans la mémoire de diagnostic. Une non-concordance entraîne le retour au menu de sélection des systèmes à tester. L'actionnement d'une touche AIDE 6d entraîne en outre, dans ce cas, l'affichage d'un message d'aide indiquant à l'utilisateur la référence du câble devant être utilisé.

Sinon l'utilisateur est amené à sélectionner le type de test qu'il désire effectuer. Les tests de base proposés consistent en :
- un test de câblage qui permet de vérifier le câblage de toute la chaîne de mesure,
- un test de mesure de paramètres qui permet la mesure de tous les paramètres se rapportant au système à tester,
- un test routier qui permet de déceler les défauts fugitifs et permanents, lors du roulage du véhicule,
- des tests spécifiques au système testé, tels que test de démarrage pour une injection ou un allumage.

La sélection du système à tester et du type de test à effectuer amènent la configuration du multiprocesseur au moyen des programmes de diagnostic qui, notamment pour un test routier :
- affectent un signal prioritaire à un signal d'état ou de commande préselectionné,
- ordonnent l'ensemble des signaux d'état et de commande en au moins un classement hiérarchique, en leur affectant pour chaque classe un poids hiérarchique déterminé visant, lors de l'apparition d'un signal de défaut sur une grandeur d'une classe donnée, à inhiber les éventuels signaux de défaut des grandeurs de la même classe correspondant à des signaux de poids hiérarchique inférieur,
- affectent à une des classes un caractère privilégié visant à inhiber les signaux de défaut des autres classes en cas d'apparition d'un signal de défaut dans ladite classe privilégiée,
- contiennent les seuils de défauts associés.

A partir de cette configuration, le multiprocesseur déclenche en temps réel les mesures et contrôles qu'il doit effectuer, et procède aux acquisitions des différentes données qu'il mémorise dans les mémoires vives.

Les mémoires vives contenant les paramètres se rapportant aux données acquises sur une période liée au signal prioritaire, sont ensuite explorées en temps réel et le multiprocesseur calcule un ensemble de grandeurs représentatives des paramètres de fonctionnement. Les grandeurs sont comparés aux seuils de défauts et les éventuels signaux de défaut sont stockés dans la mémoire sauvegardée 42, soit en tant que défaut fugitif, soit en tant que défaut permanent. Cette notion de défaut fugitif ou permanent tient compte du nombre d'apparitions de défaut.

Une fois le test routier effectué, l'utilisateur peut afficher le contenu de la mémoire sauvegardé et faire apparaître, au moyen de la touche AIDE 6d, un message d'aide à la réparation pour chaque défaut affiché.

Un exemple d'utilisation de ce boîtier de diagnostic 1 pour le test d'une injection du type MOTRONIC pour véhicule 405 Peugeot est décrit ci-dessous.

Le choix du système à tester est effectué par l'utilisateur lors de l'apparition à l'écran de la page ci-dessous. L'actionnement de la touche AIDE 6d entraîne quant à elle l'apparition du message d'aides représenté également ci-dessous. 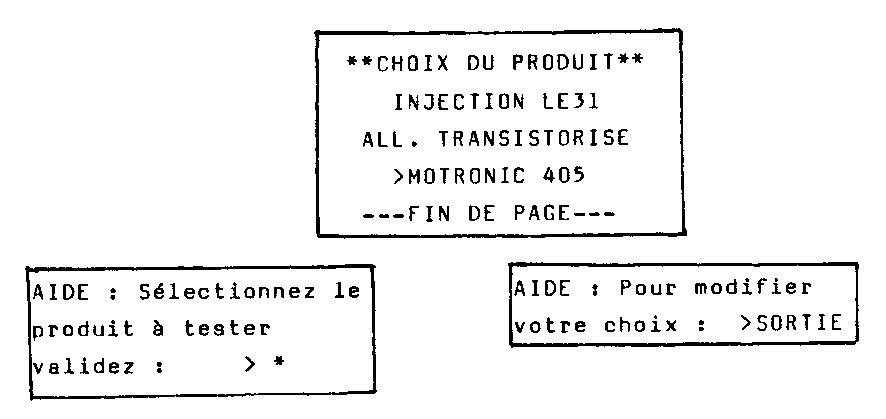
Cette sélection s'opère en déplaçant le curseur au moyen des touches montée 6b ou descente 6a et en validant le choix une fois ce curseur en face du système désiré.

Le système étant choisi, le multiprocesseur se configure de façon à traiter tous les signaux engendrés ou reçus par ce dernier selon le tableau suivant :

| CONFIGURATION DU MULTIPROCESSEUR POUR LE TRAITEMENT DE L'INJECTION MOTRONIC | |
|---|---|
| SIGNAUX A TRAITER | AFFECTATION SUR LE MULTIPROCESSEUR |
| INJECTEURS | COMPTEURS PROCESSEUR MAITRE |
| COMMANDE ALLUMAGE | |
| PRIMAIRE BOBINE | |
| ELECTROVANNE RALENTI | COMPTEURS PROCESSEUR ESCLAVE |
| CAPTEUR REGIME | |
| TEMPERATURE D'EAU | VOIES ANALOGIQUES PROCESSEUR MAITRE |
| TEMPERATURE D'AIR | |
| VREF DEBITMETRE | VOIES ANALOGIQUES PROCESSEUR ESCLAVE |
| DEBIT D'AIR | |
| REGLAGE RALENTI | |
| CONTROLES DE MASSE | VOIES LOGIQUES PROCESSEUR ESCLAVE |
| ALIMENTATIONS | VOIES LOGIQUES PROCESSEUR MAITRE |
| RELAIS POMPE | |
| PIED LEVE - PLEIN GAZ | |
| LIAISON DIAGNOSTIC | PROCESSEUR ESCLAVE |

Le menu suivant, tel qu'indiqué ci-dessous, permet à l'utilisateur d'effectuer la sélection du type de diagnostic désiré. 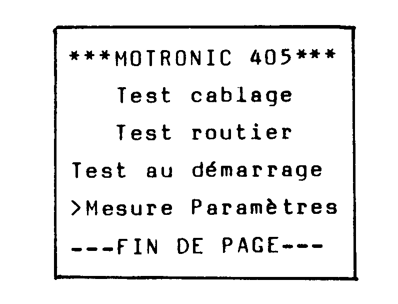
Si, par exemple, le choix d'un test de mesures est effectué, au moins une fraction de la mémoire vive est ensuite affichée en temps réel permettant de visualiser la valeur de paramètres de fonctionnement indiqués ci-dessous. 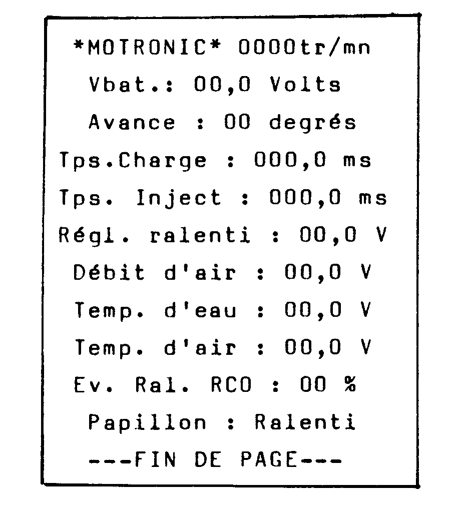
Les mesures, calculs et affichages des paramètres de fonctionnement sont alors effectués jusqu'à ce que l'utilisateur actionne la touche SORTIE 6e entraînant l'arrêt du traitement et l'affichage de la page comportant le menu de tests.

Si le choix porte alors sur un test routier, le diagnostic étant effectué sur un système (injection), d'une part associé à un organe tournant, à savoir cible tournante d'allumage et, d'autre part recevant un signal d'état, dit signal de vitesse, représentatif de la vitesse de cet organe tournant et de sa position angulaire à chaque instant, le multiprocesseur est configuré de façon à affecter un caractère prioritaire à ce signal de vitesse.

De plus, ce multiprocesseur est configuré de façon à ordonner les signaux d'état et de commande en au moins cinq classes ordonnées dans l'ordre suivant :
. première classe ayant un caractère privilégié : signaux de tension batterie, signaux de contrôle de masse,
. deuxième classe : signal de vitesse engendré par la cible d'allumage, signaux de bobine d'allumeur,
. troisième classe : signal de vitesse engendré par la cible d'allumage, signal de relais pompe, signal de commande injecteur,
. quatrième classe : signaux de débitmètre, signal de capteur de température d'air,
. cinquième classe : signal d'électrovanne, signal de capteur de température d'eau.

La page suivante est alors affichée à l'écran permettant à l'utilisateur de sélectionner la zone de la mémoire sauvegardée 42 dans laquelle seront mémorisés les signaux de défaut, la zone restante permettant d'effectuer un test similaire sur un deuxième véhicule. 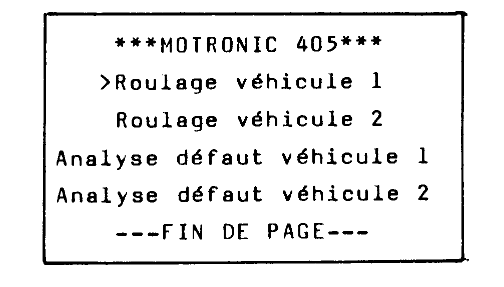
Le lancement du test routier effaçant le contenu de la zone précitée de la mémoire sauvegardée 42, l'utilisateur est alors mis en garde comme indiqué ci-dessous : 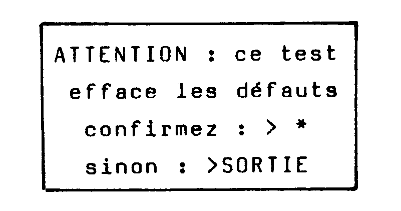
Suite à l'actionnement de la touche VALID 6c, le dispositif effectue des tests avant roulage en vue de détecter d'éventuels défauts majeurs rendant inutile le test routier et visant notamment :
- l'absence de contact comme indiqué ci-dessous avec les pages d'aide associées : 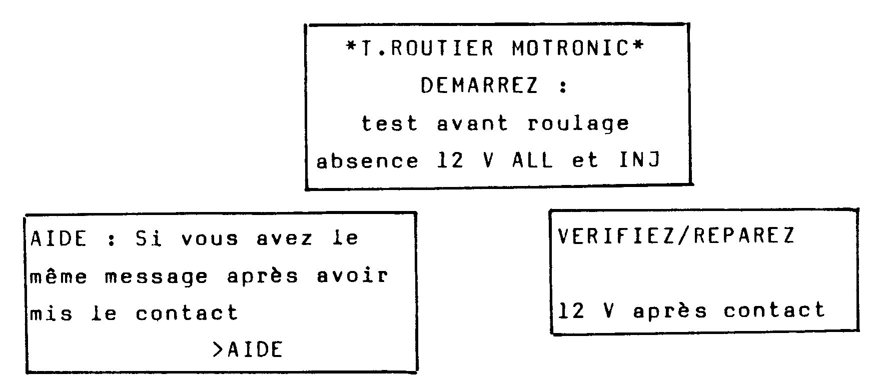
- puis d'autres tests pendant le déroulement desquels s'affiche la page suivante : 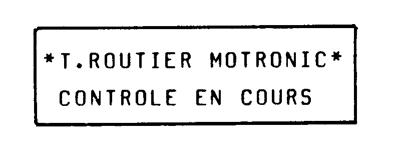
La fin de ces tests est signalée par l'affichage de la page ci-dessous qui permet à l'utilisateur, soit de continuer le test routier, soit d'arrêter ce dernier. 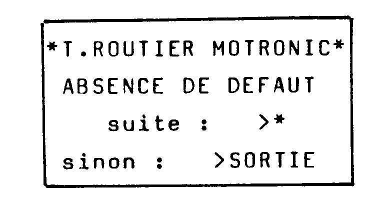
Dans la première hypothèse, le test routier est effectivement lancé, matérialisé à l'écran par l'affichage de la page suivante : 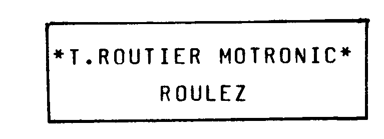
En outre, au cours de ce test, l'utilisateur est visuellement informé de la détection de défauts par l'apparition du message suivant : 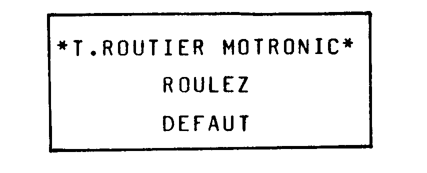
Une fois, le test terminé, l'actionnement de la touche SORTIE 6e entraîne l'arrêt du test routier et le retour au menu indiqué ci-dessous permettant de choisir l'étape suivant de visualisation des défauts : 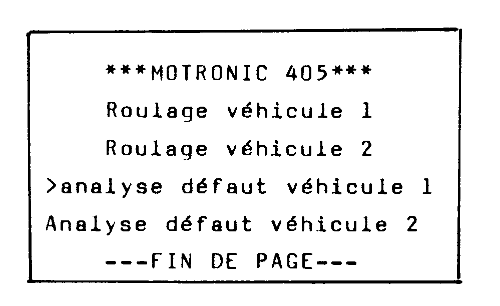
Ces défauts sont alors successivement affichés à la demande, avec pour chaque défaut une information d'aide au dépannage accessible à partir de la touche AIDE 6d. A titre d'exemple est représentée ci-dessous la signalisation du défaut de fonctionnement de l'électrovanne ralenti ainsi que la page d'aide associée : 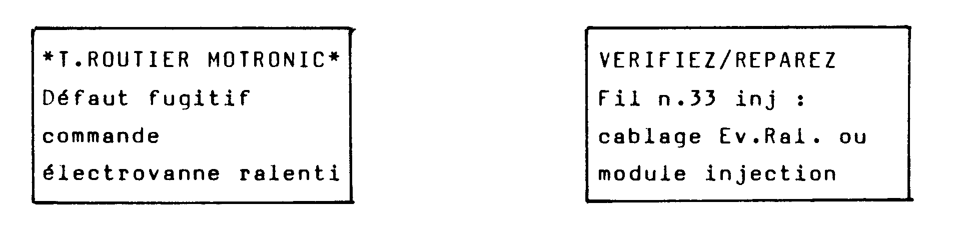
Tous les défauts peuvent ainsi être visualisés, la fin de l'énumération de ces derniers étant signifiée par l'apparition de la page suivante associée à sa page d'aide : 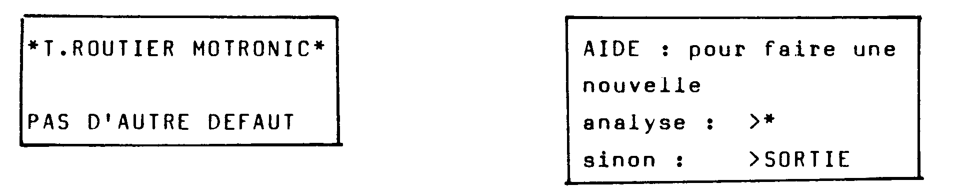
Un tel dispositif constitue donc un dispositif de diagnostic d'utilisation facile, car son principe de fonctionnement est basé sur une interactivité homme/machine poussée au maximum qui permet, à partir de la touche AIDE 6d, de guider l'utilisateur dans toutes ses commandes. De plus, en phase d'analyse des défauts, cet utilisateur a accès à des tables d'aide au dépannage facilitant notablement la réparation des pannes décelées.

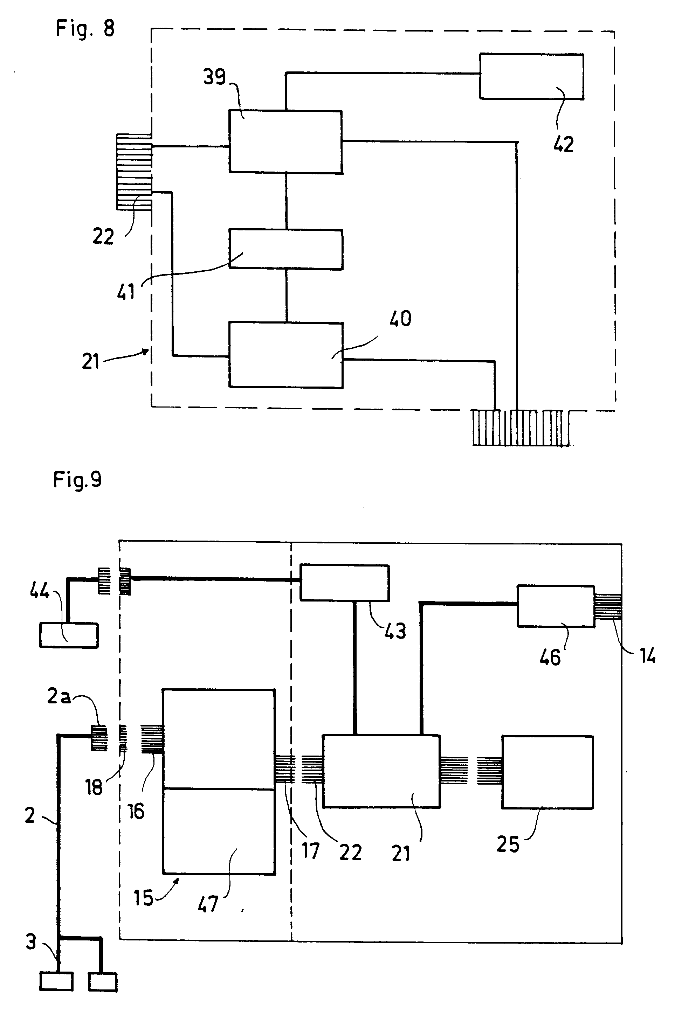

Selon une variante de réalisation et tel que représenté à la figure 9, ce boîtier de diagnostic 1 peut également fonctionner en aveugle, c'est-à-dire sans moyens d'affichage et de sélection manuelle propres. A ce moment là, ce boîtier est connecté par une liaison série avec un système extérieur d'échange avec le multiprocesseur qui comporte les moyens d'affichage et de sélection manuelle.

## Revendications

1. Procédé de diagnostic des défauts sur des boîtiers électriques ou électroniques embarqués sur véhicule automobile, boîtiers du type recevant des signaux électriques d'état caractérisant l'état statique et dynamique d'organes du véhicule et engendrant des signaux électriques de commande desdits organes, l'ensemble desdits signaux d'état et signaux de commande étant représentatifs à chaque instant d'un ensemble de paramètres spécifiques du véhicule, dits paramètres de fonctionnement, le ou les boîtiers à tester pour un véhicule donné étant désigné par "système à tester", ledit procédé étant caractérisé en ce qu'il consiste :
. à mémoriser préalablement dans des mémoires de stockage, d'une part, des programmes de diagnostic correspondant chacun à un type de système à tester, d'autre part, associés à chaque programme de diagnostic, un ensemble de seuils de défaut liés à chaque paramètre de fonctionnement correspondant au système concerné,
. à prélever en continu les signaux d'état et signaux de commande aux bornes des boîtiers du système à tester, de façon à disposer en continu desdits signaux sur un faisceau de dérivation (2),
. à mettre en forme, simultanément et en parallèle, lesdits signaux en vue de les ramener dans une plage de valeurs prédéterminée et d'obtenir des signaux calibrés,
. à sélectionner par une commande manuelle le programme de diagnostic correspondant au type de système testé, et les seuils de défaut associés,
. à configurer un multiprocesseur (21) au moyen du programme de diagnostic sélectionné, en vue de le dédier au traitement des signaux d'état et signaux de commande spécifiques du type de système testé, et d'affecter un caractère prioritaire à un des signaux d'état ou de commande de type périodique,
. à numériser, au moyen du multiprocesseur (21) configuré, les signaux calibrés et des combinaisons desdits signaux sur une période liée au signal prioritaire, de durée inférieure à celle de la période dudit signal prioritaire, de façon à engendrer au cours de ladite période un ensemble de signaux numériques représentatifs des signaux calibrés,
. à mémoriser les signaux numériques obtenus à chaque période dans une mémoire vive (41),
. à explorer ladite mémoire vive à chaque période et à calculer en temps réel un ensemble de grandeurs représentatives des paramètres de fonctionnement pour la période considérée,
. à comparer en temps réel chaque grandeur calculée aux seuils de défaut préalablement mémorisés et sélectionnés, en vue d'engendrer un signal de défaut en cas de dépassement,
. à stocker en temps réel pour chaque grandeur l'éventuel signal de défaut dans une mémoire sauvegardée (42) ayant une première zone de capacité au moins égale au nombre de paramètres de fonctionnement,
. à décompter, pour chaque grandeur, le nombre d'apparitions du signal de défaut correspondant et à mémoriser au moins une donnée liée à ce nombre dans une seconde zone de la mémoire sauvegardée (42),
. à afficher, à la demande, le contenu de ladite mémoire sauvegardée.

2. Procédé de diagnostic selon la revendication 1, caractérisé en ce que :
. l'on configure le multiprocesseur (21) au moyen du programme de diagnostic sélectionné, de façon à ordonner l'ensemble des signaux d'état et de commande en au moins un classement hiérarchique, en leur affectant, pour chaque classe, un poids hiérarchique déterminé,
. en cas d'apparition d'un signal de défaut sur une grandeur d'une classe donnée, l'on inhibe les éventuels signaux de défaut des grandeurs de la même classe correspondant à des signaux de poids hiérarchique inférieur.

3. Procédé de diagnostic selon la revendication 2, caractérisé en ce que :
. l'on configure le multiprocesseur (21) de façon à affecter à l'une des classes un caractère privilégié,
. l'on inhibe les signaux de défaut des autres classes en cas d'apparition d'un signal de défaut dans ladite classe privilégiée.

4. Procédé selon l'une des revendications 1, 2 ou 3 pour effectuer un diagnostic sur des systèmes de boîtiers associés à au moins un organe tournant, tel que cible tournante d'allumage, roue... et recevant un signal d'état, dit signal de vitesse, représentatif de la vitesse de rotation dudit organe tournant et de sa position angulaire à chaque instant, caractérisé en ce que l'on configure le multiprocesseur (21) de façon à affecter un caractère prioritaire au signal de vitesse.

5. Procédé selon les revendications 2, 3 et 4 prises ensemble, pour effectuer un diagnostic sur des systèmes de boîtiers associés à un moteur pourvu d'un ou d'organes suivants : batterie, cible d'allumage, bobine d'allumeur, injecteur, débitmètre, relais pompe, capteurs de température d'eau et d'air, électrovanne d'admission de carburant, caractérisé en ce que l'on configure le multiprocesseur (21) de façon à ordonner les signaux d'état et de commande en au moins cinq classes ordonnées dans l'ordre suivant :
. première classe ayant un caractère privilégié : signaux de tension batterie, signaux de contrôle de masse,
. deuxième classe : signal de vitesse engendré par la cible d'allumage, signaux de bobine d'allumeur,
. troisième classe : signal de vitesse engendré par la cible d'allumage, signal de relais pompe, signal de commande injecteur,
. quatrième classe : signaux de débitmètre, signal de capteur de température d'air,
. cinquième classe : signal d'électrovanne, signal de capteur de température d'eau.

6. Procédé de diagnostic selon l'une des revendications 1, 2, 3, 4 ou 5, caractérisé en ce que :
. préalablement à l'affichage du contenu de la mémoire sauvegardée (42), on sélectionne une combinaison déterminée d'informations à afficher parmi un ensemble de combinaisons correspondant à différents types de diagnostic,
. l'on affiche uniquement la combinaison d'informations sélectionnées.

7. Procédé de diagnostic selon la revendications 6, caractérisé en ce que l'on sélectionne le programme de diagnostic du système à tester et la combinaison d'informations à afficher :
. en engendrant l'affichage successif de menus portant des indications représentatives des types de système à tester mémorisés et de l'ensemble des combinaisons à afficher,
. en actionnant un curseur de choix d'indications contenues dans le menu.

8. Procédé de diagnostic selon l'une des revendications 6 ou 7, caractérisé en ce que, selon le type de diagnostic sélectionné, l'on affiche en temps réel au moins une fraction de la mémoire vive en vue de visualiser la valeur de paramètres de fonctionnement.

9. Procédé de diagnostic selon l'une des revendications précédentes, caractérisé en ce que :
. l'on mémorise dans une mémoire de stockage une table d'aides à la réparation comportant pour chaque signal de défaut des informations d'aide à la réparation,
. l'on affiche à la demande les informations de cette table qui correspondent à un signal de défaut lorsqu' est affiché ce signal de défaut.

10. Procédé de diagnostic selon l'une des revendications précédentes, caractérisé en ce que :
. l'on affecte à chaque faisceau de dérivation (2) connectable sur un système à tester un paramètre électrique, tel que résistance déterminée, identifiant ledit système à tester,
. l'on associe à chaque programme de diagnostic un code représentatif du paramètre électrique du système à tester auquel correspond ce programme de diagnostic,
. après mise en place d'un faisceau de dérivation (2) et sélection d'un programme de diagnostic, l'on vérifie la concordance du code et du paramètre électrique en vue, soit de poursuivre le diagnostic en cas de concordance, soit de bloquer le diagnostic en cas de non concordance.

11. Procédé de diagnostic selon l'une des revendications précédentes, caractérisé en ce que, sur chaque période, la numérisation de l'ensemble des signaux calibrés s'effectue en parallèle.

12. Dispositif de diagnostic en vue de la mise en oeuvre du procédé conforme à l'une des revendications 1 à 11, caractérisé en ce qu'il comprend, en combinaison :
- un jeu de faisceaux de dérivation (2), chaque faisceau comportant à une extrémité un connecteur standard (2a) et à son autre extrémité un connecteur-dérivateur (3) adapté pour se brancher aux bornes des boîtiers d'un système à tester en vue d'en dériver les signaux d'état et signaux de commande,
- une interface de mise en forme (15) dotée d'un connecteur d'entrée (16) conjugué du connecteur standard (2a) des faisceaux de dérivation (2), ladite interface comprenant une pluralité de modules de calibrage (29, 30, 31) agencés en parallèle sur les entrées,
- un multiprocesseur (21), relié à l'interface de mise en forme (15) et comprenant une pluralité de compteurs et de convertisseurs analogique/numérique, au moins deux processeurs (39, 40) organisés en maître/esclave, une mémoire vive (41) de mémorisation en temps réel des signaux numériques obtenus et une mémoire sauvegardée (42) ayant une première zone pour le stockage de signaux de défaut et une seconde zone pour mémoriser des données liées au nombre d'apparitions de chaque signal de défaut,
- des mémoires de stockage (25) d'un ensemble de programmes de diagnostic correspondant à un ensemble de systèmes à tester, lesdites mémoires étant reliées au multiprocesseur (21),
- des moyens de connexion (28 ; 14, 46 ; 47) adaptés pour connecter le multiprocesseur (21) avec une interface homme/machine possédant des moyens d'affichage et des moyens de sélection manuelle,
- des moyens d'alimentation électrique (43) pourvus d'un connecteur en vue de leur branchement sur une batterie (44) de véhicule automobile, lesdits moyens étant adaptés pour convertir la tension batterie en une tension régulée propre à l'alimentation du dispositif.

13. Dispositif de diagnostic selon la revendication 12, caractérisé en ce que l'interface de mise en forme est constituée d'une carte interchangeable (15) comportant un connecteur d'entrée débrochable (16)possédant une pluralité de voies, conjugué de connecteurs standard (2a), un connecteur de sortie débrochable (17) possédant une pluralité de voies en vue de la liaison avec le multiprocesseur (21) et, agencés en parallèle entre ces connecteurs, les modules de calibrage (29, 30, 31).

14. Dispositif de diagnostic selon la revendication 13, caractérisé en ce que l'interface de mise en forme (15) comprend une pluralité de modules de calibrage du type suivant : module (29) de comparaison du signal d'état ou de commande avec un seuil de calibrage, en vue de délivrer un signal logique fonction de la comparaison, et/ou module amplificateur suiveur (31) apte à réaliser une adaptation, en vue de délivrer un signal analogique calibré, et/ou module contrôleur de masse (30) apte à comparer l'impédance d'entrée à un seuil de calibrage, en vue de délivrer un signal logique fonction de la comparaison.

15. Dispositif de diagnostic selon l'une des revendications 12, 13 ou 14, dans lequel les mémoires de stockage des programmes de diagnostic sont portées par une carte interchangeable (25) comportant un connecteur bidirectionnel débrochable (27), en vue de la liaison desdites mémoires avec le multiprocesseur (21).

16. Dispositif de diagnostic selon l'une des revendications 12, 13, 14 ou 15, caractérisé en ce que le multiprocesseur (21) comprend au moins six compteurs par processeur (39, 40), associés par groupes de puissances différentes, en vue d'effectuer des mesures de temps sur les signaux calibrés logiques et sur des combinaisons de complexités différentes de ces signaux.

17. Dispositif de diagnostic selon l'une des revendications 12 à 16, caractérisé en ce que le multiprocesseur (21) comprend une pluralité de convertisseurs à plusieurs voies, en nombre adapté pour la numérisation en parallèle des signaux calibrés analogiques.

18. Dispositif selon l'une des revendications 12 à 17, caractérisé en ce qu'il comprend des moyens d'affichage (5) et des moyens de sélection manuelle (6) intégrés, les moyens de connection (28) de ceux-ci avec le multiprocesseur (21) étant débrochables.

19. Dispositif selon la revendication 18, caractérisé en ce que les moyens d'affichage comprennent un écran alphanumérique (5) d'au moins quatre lignes de vingt caractères et les moyens de sélection manuelle comprennent des touches (6) de sélection et de déplacement d'un curseur sur l'écran d'affichage (5).

20. Dispositif selon l'une des revendications 12 à 17, caractérisé en ce que les moyens de connexion avec l'interface homme/machine sont constitués d'un connecteur accessible (14 ; 11) en attente.

21. Dispositif selon la revendication 20, caractérisé en ce qu'il comprend une liaison série normalisée (46) reliée au multiprocesseur (21) et possédant un connecteur propre accessible (14), en vue d'une connexion sur un système extérieur d'échange avec le multiprocesseur.

22. Dispositif selon l'une des revendications 13 et 16 prises ensemble comprenant :
- un boîtier parallélépipédique (1) ouvert à deux extrémités et doté intérieurement de glissières d'anfichage de cartes,
- la carte d'interface de mise en forme (15) et la carte des mémoires de stockage (25) enfichées de façon amovible dans les glissières,
- une carte multiprocesseur (21),
- une carte de connexion (28) avec les moyens d'affichage (5) et les moyens de sélection manuelle (6),
- et deux embouts (9, 10) fermant le boîtier (1) à ses extrémités ouvertes, l'un amovible (9) portant les liaisons inter-cartes et l'autre (10) portant les connecteurs d'entrée (11-14) brochés sur la carte d'interface de mise en forme (15).

23. Dispositif selon la revendication 22, caractérisé en ce que le boîtier (1) comprend une fenêtre (4) ménagée sur une face frontale, à l'arrière de laquelle sont disposés l'écran (5) des moyens d'affichage et des boutons étanches (6) de sélection manuelle, un capot de protection (7) monté sur glissières (8) étant associé à ladite face frontale pour pouvoir se déplacer entre deux positions : une position où il masque et protège l'écran d'affichage (5) et les boutons de sélection manuelle (6), et une position où il découvre ces derniers.

24. Dispositif selon l'une des revendications 12 à 23, caractérisé en ce que chaque faisceau de dérivation (2) comprend des résistances, différentes d'un faisceau à l'autre, câblées dans ledit faisceau.

25. Carte d'interface de mise en forme (15) destinée à équiper un dispositif conforme à l'une des revendications 12 à 24, caractérisée en ce qu'elle comprend :
- un connecteur d'entrée débrochable (16) possédant une pluralité de voies,
- un connecteur de sortie débrochable (17) possédant une pluralité de voies,
- une pluralité de modules de calibrage (29, 30, 31) agencés en parallèle entre les connecteurs d'entrée et de sortie.

## Claims

1. Method for diagnosing defects in electric or electronic casings in a motor vehicle, said casings being of the type receiving electric state signals characterising the static and dynamic states of vehicle units and generating electric signals to control said units, whereby the totality of said state signals and control signals is, at every instant, representative of a totality of specific vehicle parameters, so-called operational parameters, with the casing or casings to be tested in respect of a vehicle being designated by the term "system to be tested", said method being characterised in that it consists :
. in prestoring in storage memories on the one hand diagnostic programmes each of which corresponds to a type of system to be tested and on the other hand, associated with each diagnostic programme, a totality of fault thresholds linked with each operational parameter corresponding to the system in question,
. in continuously taking state and control signals at the terminals of the casings of the system to be tested, so as to have said signals continuously available in a branching conductor bundle (2),
. in shaping, simultaneously and in parallel, said signals with a view to bringing them within a predetermined range of values and obtaining calibrated signals,
. in selecting, by means of a manual control, the diagnostic programme corresponding to the type of system tested as well as the associated fault thresholds,
. in configuring a multiprocessor (21) by means of the selected diagnostic programme with a view to dedicating said multiprocessor to the treatment of specific state and control signals of the type of system tested while assigning a priority character to one of the state or control signals of periodic type,
. in digitalising, by means of the configured multiprocessor (21), the calibrated signals and combinations of said signals within a period associated with the priority signal, whereby the duration of said period is shorter than that of the period of said priority signal, so as to generate, in the course of said period, a totality of digital signals representative of the calibrated signals,
. in storing the digital signals obtained in each period in a volatile memory (41),
. in scanning said volatile memory in each period and in calculating, in real time, a totality of values representative of the operational parameters for the period in question,
. in comparing, in real time, each value calculated at the prestored and selected fault thresholds so as to generate a fault signal if a threshold is exceeded,
. in storing, in real time, for each value the possible fault signal in a read-only memory (42) having a first zone with a capacity at least equal to the number of operational parameters,
. in deducting, for each value, the number of occurrences of the corresponding fault signal and in storing at least one item of data associated with this number in a second zone of read-only memory (42),
. in displaying, on request, the content of said read-only memory.

2. Method for diagnosing according to Claim 1, characterised in that :
. multiprocessor (21) is configured by means of the selected diagnostic programme so as to sort the totality of state and control signals in at least one hierarchic classification, by assigning to them, for each class, a definite hierarchic weight,
. if a fault signal occurs in respect of a value of a given class, the possible default signals of the values of the same class corresponding to signals of lower hierarchic weight are inhibited.

3. Method for diagnosing according to Claim 2, characterised in that :
. multiprocessor (21) is so configured as to assign to one of the classes a privileged character,
. the fault signals of the other classes are inhibited if a fault signals occurs in said privileged class.

4. Method according to one of Claims 1, 2 or 3 for effecting a diagnosis in respect of casing systems associated with at least one revolving unit such as a revolving distributor, wheel ... and receiving a state signal, a so-called signal of speed, representative of the rotary speed of said revolving unit and its angular position at every instance, characterised in that multiprocessor (21) is so configured as to assign a priority character to the signal of speed.

5. Method according to Claims 2, 3 and 4 jointly for effecting a diagnosis in respect of casing systems associated with an engine having one or more of the following units: battery, distributor, ignition coil, injector, flow meter, pump relay, sensors for water and air temperature and fuel inlet solenoid, characterised in that multiprocessor (21) is so configured as to sort the state and control signals in at least five classes sorted in the following order :
. first class with privileged character: battery voltage signals, earth control signals,
. second class: signal of speed generated by distributor, ignition coil signals,
. third class: signal of speed generated by distributor, relay pump signal, injector control signal,
. fourth class: flow meter signals, signal from air temperature sensor,
. fifth class: solenoid signal, signal from water temperature sensor.

6. Method for diagnosing according to one of Claims 1, 2, 3, 4 or 5, characterised in that :
. prior to displaying the content of read-only memory (42), a definite combination of data to be displayed is selected from a totality of combinations corresponding to different types of diagnosis,
. only the combination of selected data is displayed.

7. Method for diagnosing according to Claim 6, characterised in that the programme for diagnosing the system to be tested and the combination of data to be displayed are selected :
. causing successive display of menus comprising representative indications of the stored types of system to be tested and of the totality of combinations to be displayed,
. activating a cursor for selecting indications from the menu.

8. Method for diagnosing according to one of Claims 6 or 7, characterised in that, depending on the diagnostic programme selected, at least one fraction of the volatile memory is displayed in real time with a view to showing in visual manner the values of operational parameters.

9. Method for diagnosing according to one of the preceding claims, characterised in that :
. a table of repair aids is stored in a storage memory, whereby said table comprises for each fault signal repair aid data,
. the data contained in this table are displayed on request, said data corresponding to a fault signal when said fault signal is displayed.

10. Method for diagnosing according to one of the preceding claims, characterised in that :
. to each branching conductor bundle (2) which can be connected to a system to be tested, an electric parameter identifying said system to be tested is assigned, e.g. a specified resistance,
. a code is associated with each diagnostic programme, said code being representative of the electric parameter of the system to be tested to which said diagnostic programme corresponds,
. after installing a branching conductor bundle (2) and selecting a diagnostic programme, the correspondence of the code and the electric parameter is verified with a view to proceeding with the diagnosis in case of correspondence or blocking the diagnosis in the absence of correspondence.

11. Method for diagnosing according to one of the preceding claims, characterised in that, in each period, digitalisation of the totality of calibrated signals is effected in parallel.

12. Apparatus for diagnosing with a view to implementing the method according to one of Claims 1 to 11, characterised in that it comprises in combination :
- a set of branching conductor bundles (2), whereby each bundle comprises a standard connector (2a) at one end and a branching connector (3) at its other end, said branching connector being such as to connect with the terminals of casings pertaining to a system to be tested with a view to deriving the state signals and control signals therefrom,
- a shaping interface (15) endowed with an input connector (16) fitting standard connector (2a) of branching conductor bundles (2), whereby said interface comprises a plurality of calibrating modules (29, 30, 31) arranged in parallel at the inputs,
- a multiprocessor (21) connected to shaping interface (15) and comprising a plurality of counters and analogue/digital converters, at least two processors (39, 40) in master/slave relationship, a volatile memory (41) for storing in real time the digital signals obtained and a read-only memory (42) having a first zone for storing fault signals and a second zone for storing the data associated with the number of occurrences of each fault signal,
- storage memories (25) of a totality of diagnostic programmes corresponding to a totality of systems to be tested, said memories being linked with multiprocessor (21),
- connection means (28; 14, 46; 47) designed to connect multiprocessor (21) with an interface between an operator and a machine having means for display and means for manual selection,
- electric supply means (43) provided with a connector so as to enable them to be connected with a motor vehicle battery (44), said means being so designed as to convert the battery voltage into a regulated voltage suitable for feeding the apparatus.

13. Apparatus for diagnosing according to Claim 12, characterised in that the shaping interface consists of an interchangeable card (15) comprising a detachable input connector (16) with a plurality of channels, whereby said connector fits standard connectors (2a), a detachable output connector (17) with a plurality of channels so as to enable connection with multiprocessor (21) and, arranged in parallel between the connectors, calibrating modules (29, 30, 31).

14. Apparatus for diagnosing according to Claim 13, characterised in that shaping interface (15) comprises a plurality of calibrating modules of the following types: module (29) for comparing the state or control signal with the calibrating threshold with a view to delivering a logic signal depending on the comparison and/or follower-amplifier module (31) capable of bringing about an adaptation with a view to delivering a calibrated analogue signal and/or earth control module (30) capable of comparing the input impedance at a calibrating threshold with a view to delivering a logic signal depending on the comparison.

15. Apparatus for diagnosing according to one of Claims 12, 13 or 14, in which the memories for storing diagnostic programmes are provided on an interchangeable card (25) comprising a detachable bi-directional connector (27) with a view to connecting said memories with multiprocessor (21).

16. Apparatus for diagnosing according to one of Claims 12, 13, 14 or 15, characterised in that multiprocessor (21) comprises at least six counters per processor (39, 40) associated according to groups of different powers, with a view to effecting time measurements in respect of the logic calibrated signals and combinations of different complexities of said signals.

17. Apparatus for diagnosing according to one of Claims 12 to 16, characterised in that multiprocessor (21) comprises a plurality of converters with several channels, their number being such as to enable digitalisation in parallel of the analogue calibrated signals.

18. Apparatus according to one of Claims 12 to 17, characterised in that it comprises integrated display means (5) and means for manual selection (6), whereby means (28) for connecting said means with multiprocessor (21) are detachable.

19. Apparatus according to Claim 18, characterised in that the display means comprise an alphanumeric screen (5) with at least four lines of twenty characters and the means for manual selection comprise keys (6) for selection and displacement of the cursor on display screen (5).

20. Apparatus according to one of Claims 12 to 17, characterised in that the means for connection with the operator/machine interface consist of a connector (14; 11) accessible in standby mode.

21. Apparatus according to Claim 20, characterised in that it comprises a standardised serial link (46) connected with multiprocessor (21), whereby said link has an accessible connector (14) of its own, with a view to connection to an external exchange system with the multiprocessor.

22. Apparatus according to one of Claims 13 and 16 jointly, comprising :
- a parallelepipedic casing (1) open at two ends and endowed on its inside with card plug-in slides,
- the card for shaping interface (15) and the card for storage memories (25) which are removably plugged into the slides,
- a multiprocessor card (21),
- a connection card (28) with display means (5) and means (6) for manual selection,
- and two end pieces (9, 10) closing casing (1) at its open ends, i.e. one removable end piece (9) provided with the links between the cards whereas the other (10) is provided with input connectors (11-14) connected to shaping-interface card (15).

23. Apparatus according to Claim 22, characterised in that casing (1) comprises a window (4) arranged on a front face, behind which are located screen (5) of the display means and sealed keys (6) for manual selection, with a protective cover (7) fitted on slides (8) being associated with said front face so as to be capable of moving between two positions - a position in which it covers and protects display screen (5) and manual selection keys (6) and a position in which it uncovers the latter.

24. Apparatus according to one of Claims 12 to 23, characterised in that each branching conductor bundle (2) comprises resistances which differ from one bundle to the next and are cabled into said bundle.

25. Shaping interface card (15) for an apparatus according to one of Claims 12 to 24, characterised in that it comprises :
- a detachable input connector (16) with a plurality of channels,
- a detachable output connector (17) with a plurality of channels,
- a plurality of calibrating modules (29, 30, 31) arranged in parallel between the input and output connector.

## Patentansprüche

1. Verfahren zur Fehlerdiagnose an elektrischen oder elektronischen Gehäusen an Bord eines Kraftfahrzeugs und zwar Gehäusen der Art, die den statischen und dynamischen Zustand von Fahrzeugeinrichtungen kennzeichnende elektrische Zustandssignale erhalten und elektrische Signale zur Steuerung der besagten Einrichtungen generieren, wobei die Gesamtheit der besagten Zustandssignale und Steuersignale in jedem Augenblick für eine Gesamtheit spezifischer Fahrzeugparameter, die sogenannten Betriebsparameter, repräsentativ ist, während das oder die im Zusammenhang mit einem bestimmten Fahrzeug zu prüfenden Gehäuse als das "zu prüfende System" bezeichnet werden und das besagte Verfahren dadurch gekennzeichnet ist, daß es in den folgenden Funktionen besteht :
. im Vorspeichern innerhalb von Speichern von einerseits Diagnoseprogrammen, von denen jedes einem Typ von zu prüfendem System entspricht, und andererseits, in Verbindung mit jedem Diagnoseprogramm, einer Gesamtheit von mit jedem dem betreffenden System entsprechenden Betriebsparameter in Verbindung stehenden Fehlerschwellwerten,
. in laufender Abnahme der Zustandssignale und Steuersignale an den Klemmen der Gehäuse des zu prüfenden Systems, so daß die besagten Signale laufend an einem Abzweigleiterbündel (2) verfügbar sind,
. im gleichzeitigen und parallelen Formen der besagten Signale, um sie in eine vorbestimmte Spanne von Werten zu bringen und geeichte Signale zu erzielen,
. im Wählen durch manuelle Steuerung des dem Typ von geprüftem System entsprechenden Diagnoseprogramms und der damit in Verbindung stehenden Fehlerschwellwerte,
. im Konfigurieren eines Mehrprozessorsystems (21) mit Hilfe des gewählten Diagnoseprogramms, um es für die Behandlung der spezifischen Zustandssignale und Steuersignale des Typs von geprüftem System einzustellen, und um einem der Zustands- oder Steuersignale periodischer Art einen Vorzugscharakter zu vermitteln,
. im Digitalisieren, mit Hilfe des konfigurierten Mehrprozessorsystems (21), der geeichten Signale sowie von Kombinationen der besagten Signale während einer mit dem Vorzugssignal in Verbindung stehenden Periode, deren Dauer geringer ist als die der Periode des besagten Vorzugssignals, um im Laufe der besagten Periode eine Gesamtheit von für die geeichten Signale repräsentativen digitalen Signale zu generieren,
. im Speichern der in jeder Periode erhaltenen digitalen Signale in einem flüchtigen Speicher (41),
. im Abtasten des besagten flüchtigen Speichers in jeder Periode und im Berechnen in Echtzeit einer Gesamtheit von für die Betriebsparameter der betreffenden Periode repräsentativen Werten,
. im in Echtzeit Vergleichen jedes berechneten Werts mit den im voraus gespeicherten und gewählten Fehlerschwellwerten, um bei deren Überschreitung ein Fehlersignal zu generieren,
. im in Echtzeit für jeden Wert Speichern des möglichen Fehlersignals in einem Festspeicher (42) mit einer ersten Zone, deren Kapazität mindestens so groß ist wie die Anzahl der Betriebsparameter,
. im Abziehen für jeden Wert der Anzahl von Fällen, in denen das entsprechende Fehlersignal aufgetaucht ist und im Speichern mindestens eines Datums, das in einer zweiten Zone des Festspeichers (42) mit dieser Anzahl in Verbindung steht,
. im nach Aufforderung Darstellen des Inhalts des besagten Festspeichers.

2. Diagnoseverfahren nach Anspruch 1, dadurch gekennzeichnet,
. daß man Mehrprozessorsystem (21) mit Hilfe des gewählten Diagnoseprogramms konfiguriert, um die Gesamtheit von Zustands- und Steuersignalen in mindestens einer hierarchischen Rangordnung zu ordnen, indem ihnen für jede Klasse ein bestimmtes hierarchisches Gewicht zugeteilt wird,
. daß man bei Auftauchen eines Fehlersignals im Zusammenhang mit einem Wert einer bestimmten Klasse die möglichen Fehlersignale von Werten der gleichen Klasse sperrt, insofern diese Signalen von niedrigerem hierarchischem Gewicht entsprechen.

3. Diagnoseverfahren nach Anspruch 2, dadurch gekennzeichnet,
. daß man Mehrprozessorsystem (21) so konfiguriert, daß einer der Klassen ein Vorzugscharakter vermittelt wird,
. daß man die Fehlersignale anderer Klassen bei Auftauchen eines Fehlersignals in der besagten Vorzugsklasse sperrt.

4. Verfahren nach einem der Ansprüche 1, 2 oder 3 zum Ausführen einer Diagnose an Gehäusesystemen, die mit mindestens einer sich drehenden Vorrichtung in Verbindung stehen, wie einem Zündverteiler, einem Rad ... und die ein Zustandssignal, das sogenannte Drehzahlsignal, empfangen, das für die Drehzahl der besagten sich drehenden Vorrichtung und deren Winkellage in jedem Augenblick repräsentativ ist, dadurch gekennzeichnet, daß man Mehrprozessorsystem (21) so konfiguriert, daß dem Drehzahlsignal ein Vorzugscharakter vermittelt wird.

5. Verfahren nach den Ansprüchen 2, 3 und 4 gemeinsam zum Durchführen einer Diagnose an Gehäusesystemen, die mit einem mit einer oder mehreren der folgenden Vorrichtungen - Batterie, Zündverteiler, Zündspule, Einspritzdüse, Durchflußmesser, Pumpenrelais, Wasser- und Lufttemperatursensoren und Kraftstoffeinlaßsolenoid - versehenen Motor in Verbindung stehen, dadurch gekennzeichnet, daß man das Mehrprozessorsystem (21) so konfiguriert, daß die Zustands- und Steuersignale in mindestens fünf Klassen in der folgenden Reihenfolge geordnet werden :
. erste Klasse mit Vorzugscharakter: Batteriespannungssignale, Erdungskontrollsignale,
. zweite Klasse: durch den Zündverteiler generiertes Drehzahlsignal, Zündspulensignale,
. dritte Klasse: durch den Zündverteiler generiertes Drehzahlsignal, Pumpenrelaissignal, Steuersignal für Einspritzdüse,
. vierte Klasse: Durchflußmessersignale, Signal des Lufttemperatursensors,
. fünfte Klasse: Solenoidsignal, Signal des Wassertemperatursensors.

6. Diagnoseverfahren nach einem der Ansprüche 1, 2, 3, 4 oder 5, dadurch gekennzeichnet,
. daß vor Darstellung des Inhalts von Festspeicher (42) eine bestimmte Kombination von darzustellenden Informationen aus einer Gesamtheit von verschiedenen Diagnosetypen entsprechenden Kombinationen gewählt wird,
. daß man ausschließlich die Kombination gewählter Informationen darstellt.

7. Diagnoseverfahren nach Anspruch 6, dadurch gekennzeichnet, daß man das Diagnoseprogramm des zu prüfenden Systems und die Kombination der darzustellenden Informationen wählt :
. indem man Darstellung der Reihe nach von Menüs der für die gespeicherten Typen des zu prüfenden Systems repräsentativen Anzeigen und der Gesamtheit von darzustellenden Kombinationen repräsentativer Anzeigen bewirkt,
. einen Cursor zur Wahl von in dem Menü enthaltenen Anzeigen betätigt.

8. Diagnoseverfahren nach einem der Ansprüche 6 oder 7, dadurch gekennzeichnet, daß man je nach der Art des gewählten Diagnoseprogramms in Echtzeit mindestens einen Bruchteil des flüchtigen Speichers darstellt, um die Werte von Betriebsparametern anzuzeigen.

9. Diagnoseverfahren nach einem der vorstehenden Ansprüche, dadurch gekennzeichnet,
. daß man in einem Speicher eine Tafel von Reparaturhilfen speichert, die für jedes Fehlersignal Reparaturhilfeinformationen umfaßt,
. daß man auf Anforderung die einem Fehlersignal entsprechenden Informationen in dieser Tafel darstellt, wenn das besagte Fehlersignal dargestellt wird.

10. Diagnoseverfahren nach einem der vorstehenden Ansprüche, dadurch gekennzeichnet,
. daß man jedem Abzweigleiterbündel (2), das mit einem zu prüfenden System verbunden werden kann, einen elektrischen Parameter wie einen bestimmten Widerstand zuteilt, der das besagte zu prüfende System kennzeichnet,
. daß man mit jedem Diagnoseprogramm einen für den elektrischen Parameter des zu prüfenden Systems, dem das besagte Diagnoseprogramm entspricht, repräsentativen Code in Verbindung bringt,
. daß man nach Installierung eines
Abzweigleiterbündels (2) und Wahl eines Diagnoseprogramms die Übereinstimmung des Codes mit dem elektrischen Parameter prüft, um entweder bei Übereinstimmung mit dem Diagnosevorgang fortzusetzen oder bei Nichtübereinstimmung den Diagnosevorgang zu sperren.

11. Diagnoseverfahren nach einem der vorstehenden Ansprüche, dadurch gekennzeichnet, daß in jeder Periode die Digitalisierung der Gesamtheit geeichter Signale parallel durchgeführt wird.

12. Diagnoseanordnung zur Durchführung des Verfahrens nach einem der Ansprüche 1 bis 11, dadurch gekennzeichnet, daß es in Kombination die folgenden Teile umfaßt :
- einen Satz Abzweigleiterbündel (2), wobei jedes Bündel an einem Ende einen Standardsteckerteil (2a) und an seinem anderen Ende einen Abzweigsteckerteil (3) aufweist, der so beschaffen ist, daß er an die Klemmen der Gehäuse eines zu prüfenden Systems angeschlossen werden kann, um von den besagten Klemmen die Zustandssignale und die Steuersignale abzunehmen,
- eine Formgebungsschnittstelle (15) mit einem zu Standardsteckerteil (2a) der Abzweigleiterbündel (2) passenden Eingangssteckerteil (16), wobei die besagte Schnittstelle eine Mehrzahl von parallel an den Eingängen angeordneten Eichbausteinen (29, 30, 31) umfaßt,
- ein Mehrprozessorsystem (21), das mit Formgebungsschnittstelle (15) in Verbindung steht und eine Mehrzahl von Zählern und Analog/Digital-Umformern umfaßt, sowie mindestens zwei Prozessoren (39, 40), von denen der eine übergeordnet und der andere untergeordnet ist, einen flüchtigen Speicher (41) zum Speichern der gewonnenen digitalen Signale in Echtzeit und einen Festspeicher (42) mit einer ersten Zone zum Speichern von Fehlersignalen und einer zweiten Zone zum Speichern der mit der Anzahl von Fällen, in denen jedes Fehlersignal aufgetaucht ist, in Verbindung stehenden Daten,
- Speichervorrichtungen (25) einer einer Gesamtheit von zu prüfenden Systemen entsprechenden Gesamtheit von Diagnoseprogrammen, wobei die besagten Speicher mit dem Mehrprozessorsystem (21) in Verbindung stehen,
- Anschlußmittel (28; 14, 46; 47), die so beschaffen sind, daß sie Anschluß des Mehrprozessorsystems (21) an eine Schnittstelle zwischen dem Bediener und einer Maschine mit Anzeigemitteln und Mitteln für manuelle Wahl gestatten,
- Mittel zur Speisung mit elektrischem Strom (43), die zwecks Anschluß an eine Batterie (44) des Kraftfahrzeugs mit einem Steckerteil versehen sind, wobei die besagten Mittel so beschaffen sind, daß sie die Batteriespannung in eine für die Stromversorgung der Anordnung geeignete geregelte Spannung umformen.

13. Diagnoseanordnung nach Anspruch 12, dadurch gekennzeichnet, daß die Formgebungsschnittstelle in einer austauschbaren Karte (15) besteht, die einen zu Standardsteckerteilen (2a) passenden lösbaren Eingangssteckerteil (16) mit einer Mehrzahl von Kanälen umfaßt, sowie einen lösbaren Ausgangssteckerteil (17) mit einer Mehrzahl von Kanälen zwecks Anschluß an Mehrprozessorsystem (21) und, in paralleler Anordnung zwischen den besagten Steckerteilen, Eichbausteine (29, 30, 31).

14. Diagnoseanordnung nach Anspruch 13, dadurch gekennzeichnet, daß Formgebungsschnittstelle (15) eine Mehrzahl von Eichbausteinen folgender Typen umfaßt: Baustein (29) zum Vergleichen des Zustands oder Steuersignals mit einem Eichschwellwert, um ein von dem Vergleich abhängiges Logiksignal zu liefern, und/oder Folgeverstärkerbaustein (31), der in der Lage ist, zwecks Lieferung eines geeichten Analogsignals eine Anpassung zu bewirken, und/oder Erdungskontrollbaustein (30), der so beschaffen ist, daß er die Eingangsimpedanz mit einem Eichschwellwert vergleicht, um ein von dem Vergleich abhängiges Logiksignal zu liefern.

15. Diagnoseanordnung nach einem der Ansprüche 12, 13 oder 14, bei dem die Diagnoseprogrammspeicher auf einer austauschbaren Karte (25) angeordnet sind, die zwecks Verbindung der besagten Speicher mit dem Mehrprozessorsystem (21) einen lösbaren Zweigwegsteckerteil (27) umfassen.

16. Diagnoseanordnung nach einem der Ansprüche 12, 13, 14 oder 15, dadurch gekennzeichnet, daß Mehrprozessorsystem (21) mindestens sechs Zähler je Prozessor (39, 40) umfaßt, die nach Gruppen unterschiedlicher Leistungen verbunden sind, um hinsichtlich der geeichten Logiksignale und Kombinationen verschiedener Kompliziertheit dieser Signale Zeitmessungen vorzunehmen.

17. Diagnoseanordnung nach einem der Ansprüche 12 bis 16, dadurch gekennzeichnet, daß Mehrprozessorsystem (21) eine Mehrzahl von Umformern mit mehreren Kanälen umfaßt, deren Anzahl so beschaffen ist, daß sie Paralleldigitalisierung der geeichten Analogsignale gestatten.

18. Anordnung nach einem der Ansprüche 12 bis 17, dadurch gekennzeichnet, daß sie integrierte Darstellmittel (5) und Mittel für manuelle Wahl (6) umfaßt, wobei die Mittel zur Verbindung (28) der besagten Mittel mit Mehrprozessorsystem (21) lösbar sind.

19. Anordnung nach Anspruch 18, dadurch gekennzeichnet, daß die Darstellmittel einen alphanumerischen Bildschirm (5) mit mindestens vier Zeilen von je zwanzig Zeichen und die Mittel für manuelle Wahl Tasten (6) zur Wahl und Verlagerung eines Cursors auf Darstellungsbildschirm (5) umfassen.

20. Anordnung nach einem der Ansprüche 12 bis 17, dadurch gekennzeichnet, daß die Mittel zum Anschluß an die Schnittstelle Bediener/Maschine in einem im Bereitschaftszustand zugänglichen Steckerteil (14; 11) bestehen.

21. Anordnung nach Anspruch 20, dadurch gekennzeichnet, daß sie eine genormte Reihenverbindung (46) umfaßt, die am Mehrprozessorsystem (21) angeschlossen ist und zwecks Anschluß an ein externes Austauschsystem mit dem Mehrprozessorsystem einen eigenen zugänglichen Steckerteil (14) aufweist.

22. Anordnung nach einem der Ansprüche 13 und 16 gemeinsam, umfassend :
- ein parallelepipedisches Gehäuse (1), das an zwei Enden offen und im Innern mit Karteneinschubschienen versehen ist,
- die Formgebungsschnittstellenkarte (15) und die Speicherkarte (25), die auf entfernbare Weise in die Schienen eingeschoben sind,
- eine Mehrprozessorkarte (21),
- eine Karte (28) zur Verbindung mit den Darstellmitteln (5) und den Mitteln für manuelle Wahl (6),
- und zwei Endstücke (9, 10), die Gehäuse (1) an dessen offenen Enden verschließen, wobei das eine entfernbare Endstück (9) die Verbindungen zwischen den Karten umfaßt und das andere Endstück (10) die Eingangssteckerteile (11-14) trägt, die an Formgebungsschnittstellenkarte (15) angeschlossen sind.

23. Anordnung nach Anspruch 22, dadurch gekennzeichnet, daß Gehäuse (1) ein an einer Frontfläche vorgesehenes Fenster (4) umfaßt, hinter dem Bildschirm (5) der Darstellmittel und die abgedichteten Tasten (6) für manuelle Wahl angeordnet sind, sowie eine Schutzkappe (7) an Schienen (8), die mit der besagten Frontfläche so verbunden ist, daß sie sich zwischen zwei Positionen - einer Position, in der sie Darstellbildschirm (5) und die Tasten (6) für manuelle Wahl abdeckt und schützt und einer Position, in der sie diese Teile freigibt - verlagern kann.

24. Anordnung nach einem der Ansprüche 12 bis 23, dadurch gekennzeichnet, daß jedes Abzweigleiterbündel (2) Widerstände umfaßt, die von einem Bündel zum anderen verschieden und in dem besagten Bündel verkabelt sind.

25. Formgebungsschnittstellenkarte (15) zur Ausstattung einer Anordnung nach einem der Ansprüche 12 bis 24, dadurch gekennzeichnet, daß sie folgende Teile umfaßt :
- einen lösbaren Eingangssteckerteil (16) mit einer Mehrzahl von Kanälen,
- einen lösbaren Ausgangssteckerteil (17) mit einer Mehrzahl von Kanälen,
- eine Mehrzahl von Eichbausteinen (29, 30, 31) in paralleler Anordnung zwischen den Eingangs- und Ausgangssteckerteilen.
